# EUROPÄISCHE PATENTANMELDUNG

(11) **EP 4 345 465 A1**
(43) Veröffentlichungstag der Anmeldung: **03.04.2024**
(21) Anmeldenummer: 22199196.1
(22) Anmeldetag: 30.09.2022
(51) Int. Cl.: G01R 15/20

(54) **STROMMESSEINRICHTUNG EINER ELEKTRISCHEN MASCHINE**

(71) Anmelder: Siemens Aktiengesellschaft, 80333 München (DE)
(72) Erfinder: Centner, Matthias, 10555 Berlin (DE); Teichert, Enrico, 16248 Lunow-Stolzenhagen (DE)
(74) Vertreter: Siemens Patent Attorneys

(57) **Zusammenfassung**

Beschrieben ist eine Strommesseinrichtung (4) für eine elektrische Maschine, mit einem Sensor (6), mit einem ersten Flussleitelement (9) und mit einem ersten Distanzierungselement (11), wobei das erste Distanzierungselement (11) Endbereiche des ersten Flussleitelementes (9) distanziert oder wobei das erste Distanzierungselement (11) das erste Flussleitelement (9) von einem zweiten Flussleitelement (10) distanziert. Bei einem Verfahren zur Messung eines Stromes einer elektrischen Maschine (1) wird eine beschriebene Strommesseinrichtung (4) verwendet.

## Beschreibung

Die Erfindung betrifft eine Strommesseinrichtung einer elektrischen Maschine bzw. ein Verfahren zur Strommessung für eine elektrische Maschine.

Bei einer elektrischen Maschine können deren Betriebsparameter und/oder Testparameter gemessen werden. Beispiele für derartige Parameter sind ein Strom bzw. eine Spannung. Derartige Messwerte, also ein Ist-Strom bzw. eine Ist-Spannung können für die Regelung, Steuerung und/oder Überwachung der elektrischen Maschine verwendet werden. Die Überwachung der elektrischen Maschine kann auch als Condition-Monitoring bezeichnet werden. Die elektrische Maschine ist beispielsweise ein Motor oder ein Generator. Die elektrische Maschine kann eine Synchronmaschine oder eine Asynchronmaschine sein. Weisen derartige elektrische Maschinen eine hohe Leistung im Bereich von Megawatt (MW) auf, so ergeben sich daraus entsprechend auch hohe elektrische Ströme und elektrische Spannungen. Beispielsweise wird zu Zwecken des Condition Monitoring als auch für Prüffeldzwecke der Strom auf dem Rotor von Synchronmaschinen gemessen und mit Hilfe von Schleifringübertragern oder kontaktlosen Telemetriesystemen übertragen. Da die Erregerströme Größenordnungen von >1000A annehmen können, sind spezielle Messgeräte zu deren Messung erforderlich, die möglichst kostengünstig sein sollen. Neben dem speziellen Problem der Strommessung auf dem Rotor besteht das Problem auch für Statorströme, die einem Monitoring-System zugänglich gemacht werden sollen. Zur Messung der Erregerströme bei Synchronmaschinen können Shunts verwendet werden. Diese Bauteile sind für einen betrachteten Strombereich von > 1000A große und in der Einzelfertigung sehr teure Bauteile. Stromwandler können alternativ zum Shunt eingesetzt werden, allerdings sind auch diese groß und teuer. Außerdem wird für rotierende Anwendungen, wie bei einem Rotor einer elektrischen Maschine, ein robuster, fliehkraftgeeigneter Aufbau verlangt.

Bei Gleichstrom kommen Stromwandler bzw. Rogowski-Spulen nicht in Frage, da diese nicht für Gleichströme geeignet sind. Spezielle LEM-Stromwandler, die für Gleichströme brauchbar sind, sind für den angestrebten Messbereich schwer zu beschaffen und ebenfalls sehr teuer. Die Messung über Shunts hat überdies den Nachteil, nicht potentialfrei zu sein.

Die Strommessung für AC-Ständerströme kann über potentialfreie Stromwandler erfolgen, da dort mit Spannungen von bis zu mehreren kV operiert wird. Stromwandler beanspruchen einen gewissen Bauraum und sind auch relativ teure Bauelemente. Es ist beispielsweise in der Regel auch nicht möglich, sich in bestehende Schutz- oder Messkreise mit einem Monitoring-System zusätzlich einzuklinken. Extra Wandler stellen dann einen nicht zu vernachlässigenden Kostenpunkt dar.

Eine Aufgabe der Erfindung ist es eine einfach Strommesseinrichtung für eine elektrische Maschine anzugeben. Eine weitere Aufgabe der Erfindung ist es ein einfaches Verfahren zur Strommessung für eine elektrische Maschine anzugeben.

Eine Lösung der Aufgabe ergibt sich nach Anspruch 1 bzw. nach Anspruch 9. Ausgestaltungen ergeben sich beispielsweise nach zumindest einem der Ansprüche 2 bis 8 und 10.

Eine Strommesseinrichtung für eine elektrische Maschine weist einen Sensor auf. Der Sensor ist insbesondere ein Hallsensor, auch Hall-Effekt-Sensor oder Hall-Stromsensor oder HallSensor genannt. Hall-Sensoren messen Magnetfelder und damit über das Durchflutungsgesetz mittelbar den Strom. Dennoch werden Hall-Sensoren oft auch als Stromsenoren bezeichnet. Hall-Stromsensoren können zur Messung von Gleich- und Wechselströmen dienen, wobei diese insbesondere im Bereich zwischen 1000 A und 10000 A liegen. Die Strommesseinrichtung weist ein erstes Flussleitelement und ein erstes Distanzierungselement auf. Damit weist die Strommesseinrichtung zumindest ein Flussleitelement und zumindest ein Distanzierungselement auf. Bei der Strommesseinrichtung distanziert das erste Distanzierungselement Endbereiche des ersten Flussleitelementes oder das erste Distanzierungselement distanziert das erste Flussleitelement von einem zweiten Flussleitelement. In einer Ausgestaltung der Strommesseinrichtung distanziert also das erste Distanzierungselement Endbereiche des ersten Flussleitelementes. In einer weiteren Ausgestaltung der Strommesseinrichtung distanziert also das erste Distanzierungselement das erste Flussleitelement vom zweiten Flussleitelement.

Mit einem Hall-Effekt-Sensor (Hallsensor)zur Messung eines magnetischen Feldes, welches durch einen stromdurchflossenen Leiter hervorgerufen werden kann, kann eine Messung des Stromes (des elektrischen Stromes) erfolgen. Der Sensor ist insbesondere in einem Chip integriert. Beim Sensor handelt es sich also insbesondere um ein integriertes Bauteil. Die Messung erfolgt insbesondere in der Chip-Ebene. Hierzu gibt es verschiedene Sensoren, welche Magnetfelder in einer oder mehreren Raumachsen messen können. Der Sensor ist im Distanzelemente in geeigneter Weise anzuordnen. Das Magnetfeld durchdringt den Sensor, wobei auch gezielt Materialien zur Leitung des Magnetfelds in unmittelbarer Nähe des Chips verwendet werden können.

Durch die Verwendung von Flussleitelement und Distanzierungselement ist praktisch eine Messung fast beliebig große Ströme mit einem Chip realisierbar. Es kann also ein Chip mit einem begrenzten Magnetfeld-Messbereich genutzt werden.

In einer Ausgestaltung der Strommesseinrichtung beruht der Aufbau darauf, dass das den stromdurchflossenen Leiter umgebende Magnetfeld gemessen wird. Da der Hallsensor eine bestimmt Feldrichtung und maximal auswertbare Feldstärke aufweist, kann der Aufbau so gestaltet sein, dass die Feldstärke leicht eingestellt werden kann und zweitens ein relativ homogener Feldverlauf im Bereich des Sensors vorliegt, um insbesondere toleranzunempfindlich zu sein.

In einer Ausgestaltung der Strommesseinrichtung ist deren Aufbau potentialfrei und beinhaltet insbesondere eine digitale Signalverarbeitung, welche die Übertragung des Sensorsignals über größere Entfernungen störungsarm bzw. störungsfrei ermöglicht.

In einer Ausgestaltung der Strommesseinrichtung umgibt zumindest ein Flussleitelement zusammen mit zumindest einem Distanzierungselement einen Stromleiter umgibt. Dabei kann sich auch zumindest ein Luftspalt ergeben. Durch diese Anordnung kann das magnetische Feld eines stromdurchflossenen elektrischen Leiters geführt werden.

In einer Ausgestaltung der Strommesseinrichtung ist zumindest ein Flussleitelement und/oder zumindest ein Distanzierungselement austauschbar ist.

In einer Ausgestaltung der Strommesseinrichtung erfolgt deren Adaption an unterschiedliche Ströme bzw. Feldstärken durch einen variablen Einsatz, d.h. einen Austausch, eines oder mehrerer Distanzierungselemente und/oder eines oder mehrerer Flussleitelemente. Distanzierungselemente können als variable Zwischenstücke zwischen Flussleitelementen betrachtet werden. Die Flussleitelemente sind beispielsweise durch ein Elektroblech bzw. durch mehrere aufeinandergeschichteten Elektroblechen realisierbar. Hieraus ergibt sich ein Leitblechaufbau.

In einer Ausgestaltung der Strommesseinrichtung sind Flussleitelemente aus einem Material mit besonders schmaler Hystereseschleife, wie z.B. mu-Metall. So kann Einfluss auf die erreichbare Messgenauigkeit genommen werden (insbesondere eine vorteilhafte Verbesserung der Messgenauigkeit).

In einer Ausgestaltung der Strommesseinrichtung ist das Flussleitelement bzw. sind die Flussleitelemente insbesondere in einem Bereich, welcher einen elektrischen Leiter umgibt, derart geometrisch ausgeformt, dass deren geometrische Form den magnetischen Feldlinien um den elektrischen Leiter folgt.

Anders formuliert folgt letztlich das Feld dem magnetischen Leiter.

In einer Ausgestaltung der Strommesseinrichtung ist ein Sensorträger mit dem Sensor bei geometrisch verschiedenen Flussleitelementen und oder bei geometrisch verschiedenen Distanzierungselement welche zum Austausch kommen eingesetzt. Der Sensorträger ist beispielsweise eine Elektronikplatine oder ein Träger für eine Elektronikplatine, auf welcher sich der Sensor befindet.

In einer Ausgestaltung der Strommesseinrichtung weist diese zumindest ein Verbindungselement auf, welches das Distanzierungselement mit dem Flussleitelement verbindet, wobei das Verbindungselement insbesondere ein nichtmagnetisches Material aufweist. Das Verbindungselement ist beispielsweise eine Verspanneinrichtung, ein Kabelbinder, eine Schraube, etc. Als Material kann beispielsweise Kupfer oder ein Kunststoff verwendet werden.

In einer Ausgestaltung der Strommesseinrichtung ist der Sensor in einem Distanzierungsbereich angeordnet. So kann der Sensor und/oder der Sensorträger beispielsweise von einem Distanzierungselement gehalten werden bzw. in diesem positioniert werden.

In einer Ausgestaltung der Strommesseinrichtung ist der Sensor in einem Bereich homogener Magnetfeldlinien angeordnet. Dies ermöglicht eine verbesserte Messgenauigkeit.

In einer Ausgestaltung der Strommesseinrichtung ist der Sensor in einem Mindestabstand zu einem Leiter (elektrischer Leiter) angeordnet. Dadurch kann erreicht werden, dass der Sensor besser in einem Bereich positioniert werden kann, in dem das Magnetfeld homogen verläuft.

In einer Ausgestaltung der Strommesseinrichtung ist zumindest ein Flussleitelement geblecht ausgeführt. So können Wirbelströme bzw. Wirbelstromverluste reduziert werden.

In einer Ausgestaltung der Strommesseinrichtung weist diese eine Funkeinrichtung zur kabellosen Übertragung der durch den Sensor erfassten Messignale auf.

Bei einem Verfahren zur Messung eines Stromes einer elektrischen Maschine wird eine Strommesseinrichtung nach einer der beschriebenen Ausgestaltungen verwendet.

In einer Ausgestaltung des Verfahrens wird ein Rotorstrom oder ein Statorstrom einer elektrischen Maschine gemessen. Durch die Variabilität der Strommesseinrichtung kann der gleiche Sensor bei unterschiedlich elektrischen Maschinen mit unterschiedlichen Leistungen eingesetzt werden.

In einer Ausgestaltung des Verfahrens wird zur Messung unterschiedlicher Ströme, insbesondere unterschiedlicher maximaler Ströme, zumindest ein Distanzierungselement ausgetauscht. Damit kann ein Strommesseinrichtung flexibel eingesetzt werden.

Durch eine Variabilität der Strommesseinrichtung können die Kosten, im Vergleich zu einem Shunt, vergleichsweise geringgehalten werden. Weiterhin kann sich ein vergleichsweise sehr kompakter Aufbau ergeben. Ein weiterer Vorteil der Strommesseinrichtung kann sich durch eine nicht intrusive Art des Einbaus ergeben (der Stromkreis muss nicht geöffnet werden). Ein weiterer Vorteil der Strommesseinrichtung kann sich durch deren möglichen potentialfreien Aufbau ergeben. Gerade bei höhen Strömen bzw. Spannungen kann die Potentialfreiheit von Bedeutung sein. Durch eine mögliche Verwendung eines integrierten Hall-Sensors in Kombination mit einem Mikrocontroller (insbesondere einem günstigen Mikrokontroller) und/oder von einfachen Bauteilen (z.B.: Bleche für Flussleitelemente, 3D-gedruckte Kunststoffstrukturen für Distanzierungselemente bzw. Messingschrauben) sind die Kosten sehr gering, der Aufbau flexibel und robust.

In einer Ausgestaltung der Strommesseinrichtung bzw. des Verfahrens können sich Möglichkeiten zu Einsparungen im Vergleich zum bisher verwendeten Shunt und weitere Sparpotenziale ergeben, wenn der Sensor auch für Strommessung in anderen Bereichen verwendet wird (z.B. Condition-Monitoring Systeme o.ä.) .

Die Merkmale der einzelnen beanspruchten bzw. beschriebenen Ausführungen sind ohne Weiteres miteinander kombinierbar. Im Folgenden wird die Erfindung beispielhaft anhand von Figuren näher dargestellt und erläutert. Gleiche Bezugszeichen bezeichnen dabei in den verschiedenen Figuren gleichartige Elemente. Die in den Figuren gezeigten Merkmale können fachmännisch zu neuen Ausführungsformen kombiniert werden, ohne die Erfindung zu verlassen. Es zeigen:
- FIG 1: eine elektrische Maschine,
- FIG 2: ein Strommesseinrichtung und
- FIG 3 bis FIG 8: weitere Strommesseinrichtung.

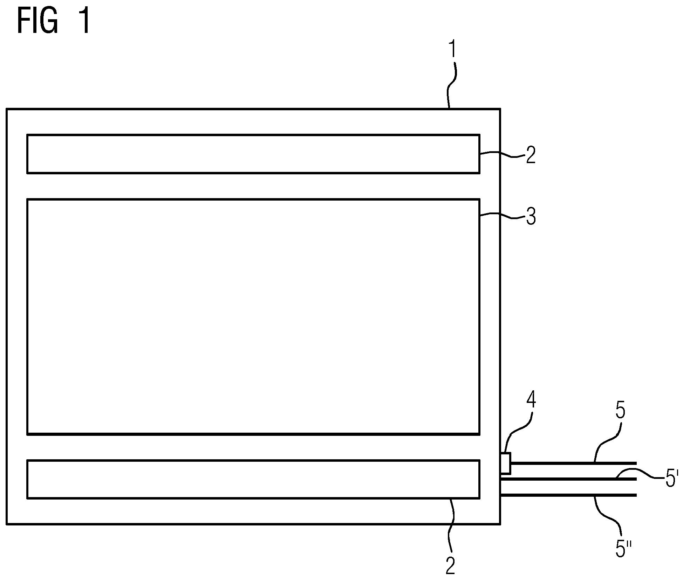

Die Darstellung nach Figur 1 zeigt eine elektrische Maschine 1 mit einem Stator 2 und einem Rotor 3. Die elektrische Maschine 1 weist einen elektrischen Anschluss mit elektrischer Stromleiter (Leitern) 5, 5', 5" auf. Zur Messung eines elektrischen Stroms (Stroms) in dem Leiter 5 ist eine Strommesseinrichtung 4 vorgesehen.

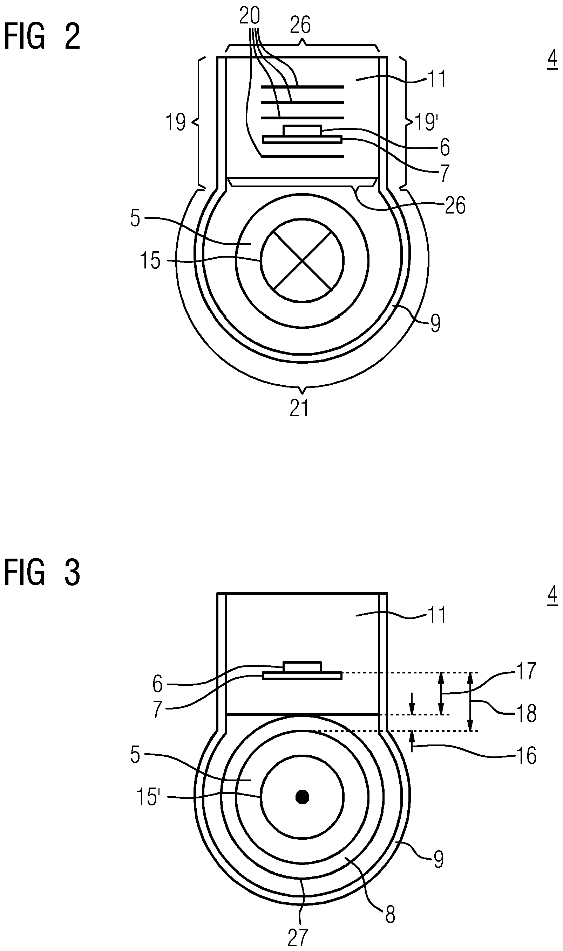

Die Darstellung nach Figur 2 zeigt eine Strommesseinrichtung 4 für einen elektrischen Stromleiter (elektrischer Leiter) 5. Der elektrische Leiter 5 in Figur 2 hat einen runden Querschnitt. Ein Stromdurchfluss durch den elektrischen Leiter 5 wird durch ein Symbol 15 dargestellt. Dieses Symbol 15 weist einen Kreis und ein in diesem Kreis befindliches Kreuz auf. Die Strommesseinrichtung 4 weist ein erstes Flussleitelement 9 auf, welches Endbereiche 19, 19' und einen dazwischenliegenden magnetischen Leitbereich 21 aufweist. Der magnetische Leitbereich 21 des Flussleitelementes 9 führt das magnetische Feld entsprechend seines Verlaufes um einen Leiter. Die Endbereiche 19, 19' dienen dazu das magnetische Feld in einem definierten Bereich zu homogenisieren bzw. zu parallelisieren. Dieser Bereich ist ein Distanzierungsbereich 26, welcher durch ein erstes Distanzierungselement 11 geschaffen ist. In diesem Bereich 26 können sich parallel verlaufende Magnetfeldlinien 20 ausbilden. In diesem Bereich, wo sich die parallel verlaufenden Magnetfeldlinien 20 ausbilden können, ist ein Sensor 6 auf einer Platine 7 positioniert. Der Sensor 6 kann beispielsweise zusammen mit der Platine 7 in eine Aussparung des Distanzierungselementes 11 geschoben bzw. positioniert werden.

Die Darstellung nach Figur 3 zeigt eine Strommesseinrichtung 4 für einen elektrischen Stromleiter 5. Auch der elektrische Leiter 5 in Figur 3 hat einen runden Querschnitt. Ein Stromdurchfluss durch den elektrischen Leiter 5 wird in Figur 3 durch ein Symbol 15' dargestellt. Dieses Symbol 15' weist einen Kreis und einen in diesem Kreis befindlichen Punkt auf. Der Punkt und das Kreuz (siehe Figur 1) weisen in diesem Zusammenhang auf unterschiedliche Stromrichtungen hin. Nach Figur 3 weist der Leiter 5 eine Isolierung 8 mit einer Dicke 16 auf. Der elektrische Leiter 5 und die Isolierung 8 ergeben ein Kabel 27 dessen Querschnitt dargestellt ist. Das Distanzierungselement 11 grenzt unmittelbar an der Isolierung 8 des Leiters 5 an. Der Sensor 6 weist einen ersten Abstand 17 vom Kabel 27 auf. Der Sensor 6 weist einen zweiten Abstand 18 vom elektrischen Leiter 5 auf. Die Abstände 17, 18 sind so groß, dass der Sensor 6 in einem Bereich mit parallel verlaufenden magnetischen Feldlinien liegt. Dies ist insbesondere für verschiedene Stromstärken sicherzustellen.

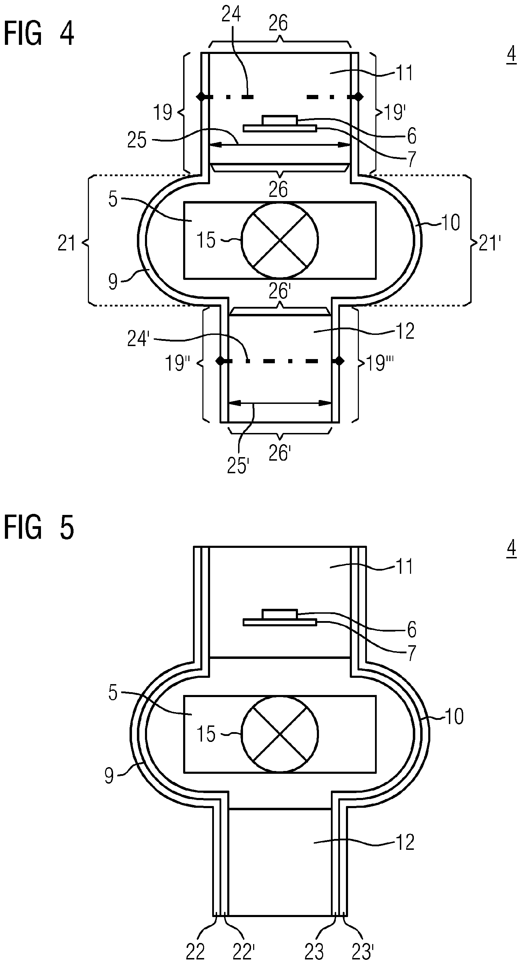

Die Darstellung nach Figur 4 zeigt eine Strommesseinrichtung 4 für einen elektrischen Stromleiter (elektrische Leiter) 5. Der elektrische Leiter 5 in Figur 4 hat einen rechteckigen Querschnitt. Gezeigt ist ferner ein erstes Flussleitelement 9 und ein zweites Flussleitelement 10. Das erste Flussleitelement 9 weist Endbereiche 19 und 19" auf. Das zweite Flussleitelement 10 weist Endbereiche 19' und 19 ‴ auf. Das erste Flussleitelement 9 ist vom zweiten Flussleitelement 10 in den Endbereichen 19 und 19' durch das erste Distanzierungselement 11 beabstandet. Ferner ist das erste Flussleitelement 9 vom zweiten Flussleitelement 10 in den Endbereichen 19" und 19‴ durch das zweite Distanzierungselement 12 beabstandet. Im ersten Distanzierungselement 11 befindet sich der Sensor 6 auf der Platine 7. Durch das erste Distanzierungselement 11 ergibt sich ein erster Distanzierungsbereich 26 mit einem Abstand 25 der Endbereiche 19 und 19'. Durch das zweite Distanzierungselement 12 ergibt sich ein zweiter Distanzierungsbereich 26"mit einem Abstand 25'der Endbereiche 19'' und 19‴. Durch ein Verbindungselement 24 wird das erste Distanzierungselement 11 mit dem ersten Flussleitelement 9 und dem zweiten Flussleitelement 10 im Distanzierungsbereich 26 verbunden. Durch ein Verbindungselement 24' wird das erste Distanzierungselement 11 mit dem ersten Flussleitelement 9 und dem zweiten Flussleitelement 10 im Distanzierungsbereich 26' verbunden. Die Flussleitelemente 9, 10 weisen magnetische Leitbereiche 21, 21' auf. Im Leitbereich weist das jeweilige Flussleitelement eine Bogenform bzw. Kreisform auf.

Die Darstellung nach Figur 5 zeigt eine Strommesseinrichtung 4 für einen elektrischen Stromleiter 5. Die Flussleitelemente 9,10 sind geblecht ausgeführt, wobei nach Figur 5 jeweils zwei Bleche 22,22',23,23' je Flussleitelement 9,10 gezeigt sind. So können Wirbelstromverluste reduziert werden.

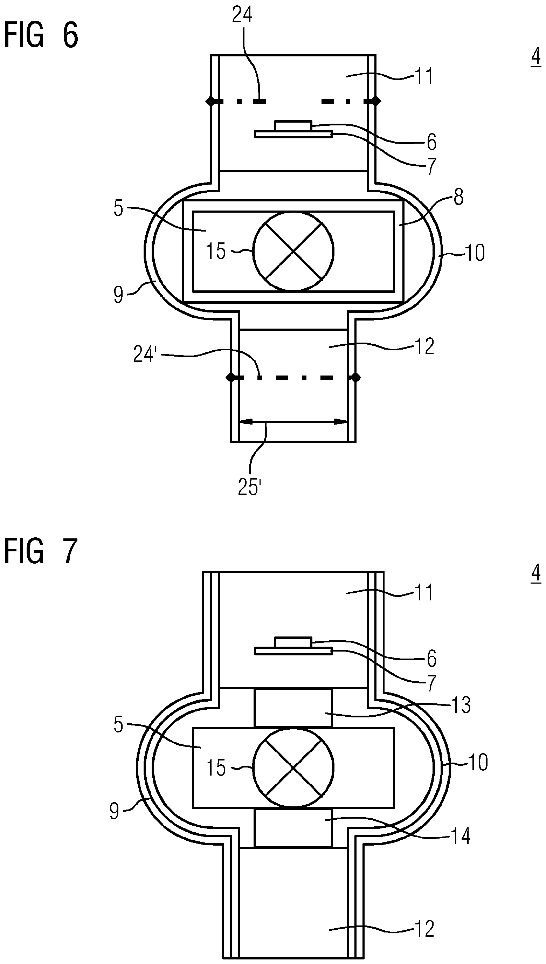

Die Darstellung nach Figur 6 zeigt eine Strommesseinrichtung 4 für einen elektrischen Stromleiter 5. Der elektrische Leiter 5 in Figur 6 hat einen rechteckigen Querschnitt mit einer Isolierung 8.

Die Darstellung nach Figur 7 zeigt eine Strommesseinrichtung 4 für einen elektrischen Stromleiter 5. Der elektrische Leiter 5 in Figur 7 ist von den Distanzierungselementen 11, 12 durch Abstandselemente 13,14 beabstandet. Durch ein erstes Abstandselement 13 und ein zweites Abstandselement 14, welche beide Isolatoren sind, ist der Stromleiter 5 in der Strommesseinrichtung 4 positioniert.

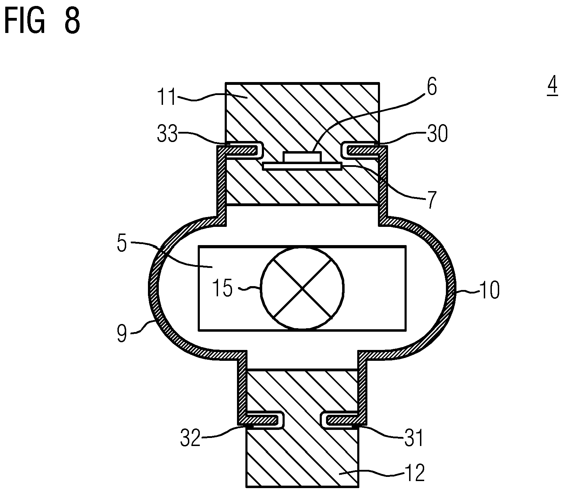

Die Darstellung nach Figur 8 zeigt eine Strommesseinrichtung 4 für einen elektrischen Stromleiter 5. Die Distanzierungselemente 12, 13 weisen Einkerbungen 30, 31, 32 und 33 auf, in welche die Flussleitelemente 9, 10 ragen. Die Einkerbungen grenzen an der Position des Sensors 6 an. Der Sensor 6 in Figur 8, weist eine zu den Sensoren 6 in den Figuren 2 bis 7 andere Geometrie auf. Dies zeigt, dass Sensoren unterschiedlicher Geometrie zum Einsatz kommen können. Die Lageposition des Sensors ist derart zu wählen bzw. zu drehen, dass eine erfolgreiche Messung durchführbar ist. Unterschiedliche Sensoren sind demnach beispielsweise zu drehen (z.B. um 90 Grad) um eine geeignete Messung zu erzielen. Der Sensor ist entsprechend der Magnetfeldrichtung in der Messumgebung und im Sensor zu orientieren.

## Patentansprüche

1. Strommesseinrichtung (4) für eine elektrische Maschine, mit einem Sensor (6), mit einem ersten Flussleitelement (9) und mit einem ersten Distanzierungselement (11), wobei das erste Distanzierungselement (11) Endbereiche des ersten Flussleitelementes (9) distanziert oder wobei das erste Distanzierungselement (11) das erste Flussleitelement (9) von einem zweiten Flussleitelement (10) distanziert.

2. Strommesseinrichtung (4) nach Anspruch 1, wobei zumindest ein Flussleitelement (9,10) zusammen mit zumindest einem Distanzierungselement (11,12) einen Stromleiter (5,5',5'') umgibt.

3. Strommesseinrichtung (4) nach Anspruch 1 oder 2, wobei zumindest ein Flussleitelement (9,10) und/oder zumindest ein Distanzierungselement (11,12) austauschbar ist.

4. Strommesseinrichtung (4) nach einem der Ansprüche 1 bis 3, wobei diese ein Verbindungselement (24,24') aufweist, welches das Distanzierungselement (11,12) mit dem Flussleitelement (9,10) verbindet, wobei das Verbindungselement (24,24') insbesondere ein nichtmagnetisches Material aufweist.

5. Strommesseinrichtung (4) nach einem der Ansprüche 1 bis 4, wobei der Sensor (6) in einem Distanzierungsbereich (26,26') angeordnet ist.

6. Strommesseinrichtung (4) nach einem der Ansprüche 1 bis 5, wobei der Sensor (6) in einem Bereich homogener Magnetfeldlinien (20) angeordnet ist.

7. Strommesseinrichtung (4) nach einem der Ansprüche 1 bis 6, wobei der Sensor (6) in einem Mindestabstand (18) zu einem Stromleiter (5,5',5'') angeordnet ist.

8. Strommesseinrichtung (4) nach einem der Ansprüche 1 bis 7, wobei zumindest ein Flussleitelement (9,10) geblecht ausgeführt ist.

9. Verfahren zur Messung eines Stromes einer elektrischen Maschine (1), wobei eine Strommesseinrichtung (4) nach einem der Ansprüche 1 bis 8 verwendet wird.

10. Verfahren nach Anspruch 9, wobei zur Messung unterschiedlicher Ströme zumindest ein Distanzierungselement (11,12) ausgetauscht wird.
